## Europäisches Patentamt
## European Patent Office
## Office européen des brevets

(19)

(11) Veröffentlichungsnummer: **0 127 015**
**B1**

(12)

# EUROPÄISCHE PATENTSCHRIFT

(45) Veröffentlichungstag der Patentschrift:
**27.12.89**

(51) Int. Cl.⁴: **G 11 C 29/00**

(21) Anmeldenummer: **84105061.0**

(22) Anmeldetag: **04.05.84**

---

(54) **Integrierte digitale MOS-Halbleiterschaltung.**

---

(30) Priorität: **20.05.83  DE 3318564**

(43) Veröffentlichungstag der Anmeldung:
**05.12.84 Patentblatt 84/49**

(45) Bekanntmachung des Hinweises auf die Patenterteilung:
**27.12.89 Patentblatt 89/52**

(84) Benannte Vertragsstaaten:
**AT DE FR GB IT**

(56) Entgegenhaltungen:
**EP-A-0 069 891**
**DE-A-2 730 917**

(73) Patentinhaber: **Siemens Aktiengesellschaft,
Wittelsbacherplatz 2, D-8000 München 2 (DE)**

(72) Erfinder: **Meyer, Willibald, Dipl.- Ing., Annette-
Kolb- Anger 15, D-8000 München 83 (DE)**
Erfinder: **Warwersig, Jürgen, Plievierpark 10,
D-8000 München 83 (DE)**

---

EP 0 127 015 B1

**Beschreibung**

Die vorliegende Erfindung betrifft eine integrierte digitale MOS-Halbleiterschaltung, die einen durch Signale mit unterschiedlichem Pegel zu beaufschlagenden Signaleingang aufweist und bei der aufgrund der Signale mit dem einen Pegel eine erste Betriebsart und aufgrund der Signale mit dem zweiten Pegel eine zweite Betriebsart, gegebenenfalls unter gleichzeitiger Stillegung der jeweiligen anderen Betriebsart, ausgelöst werden kann.

Eine solche Ausgestaltung für eine integrierte digitale MOS-Halbleiterschaltung wäre z. B. für integrierte MOS-Halbleiterspeicher mit redundanten Zeilen und Spalten - insbesondere für dynamische Speicher dieser Art - von Bedeutung. Bekanntlich weist die Matrix solcher Speicher zusätzliche Zeilen und Spalten auf, die zunächst für den Normalbetrieb des Speichers nicht vorgesehen sind. Tritt aber an einer für den Normalbetrieb vorgesehenen Speicherzelle ein Defekt auf, so hat man dann die Möglichkeit, die die defekte Zelle enthaltende Zeile bzw. Spalte durch eine solche redundante Zeile bzw. Spalte zu ersetzen. Dies geschieht, indem die redundante Zeile bzw. Spalte dann für den Normalbetrieb, für den sie zunächst gesperrt war, durch eine entsprechende Manipulation zugänglich gemacht wird, während andererseits die die defekte Zelle enthaltende Zeile bzw. Spalte bleibend stillgelegt wird. Hierzu ist es üblich, die redundanten Zeilen und Spalten durch auftrennbare Verbindungen von einem Ansprechen im Normalbetrieb abzuhalten. Die Aktivierung der redundanten Zeile bzw. Spalte erfolgt dann ebenfalls durch Auftrennen dieser Kurzschlußverbindungen. Dabei ist es häufig erforderlich, eine Möglichkeit für die Erkennung derjenigen Zeilen und Spalten der Speichermatrix zur Verfügung zu haben, die durch eine redundante Zeile bzw. Spalte ersetzt worden sind.

In der nach veröffenshichten EP-A-1 204 458 (= DE-A-3 311 427) ist ein integrierter dynamischer Schreib-Lese-Speicher beschrieben, der so ausgestaltet ist, daß der Ersatz einer für den Normalbetrieb vorgesehenen Zeile bzw. Spalte der Speichermatrix durch eine redundante Zeile bzw. Spalte durch einen logischen Pegel am Datenausgang bei einer dem sog. Roll-Call-Modus bei statischen Speichern entsprechenden Beaufschlagung mit Steuersignalen erkennbar gemacht ist. Es besteht nun die Möglichkeit, solche der Testung dienende Steuersignale auf eigens hierfür vorgesehene Signalanschlüsse der Speicherschaltung zu legen, was jedoch zu einem - aus bekannten Gründen unerwünschten-Mehraufwand an Anschlußpins für den den Speicher enthaltenden IC-Baustein führt. Man kann allerdings auch für den Normalbetrieb einerseits und für den Testbetrieb andererseits unterschiedlich eingestellte Signalspannungen verwenden, die an einen gemeinsamen externen Signaleingang gelegt werden. Hat man dann Signale des einen Pegels, so führen diese zu der einen Betriebsart und hat man Signale des anderen Pegels, so führen diese automatisch infolge einer entsprechenden inneren Ausgestaltung der integrierten Schaltung zu der anderen Betriebsart. Hierzu ist eine die Umschaltung bewirkende Umschaltanlage erforderlich, die aufgrund eines auf den gemeinsam durch die beiden Signalarten zu beaufschlagenden externen Signaleingang gelegten Signals automatisch feststellt, ob das angelegte Signal für den Normalbetrieb oder z. B. für den Testbetrieb vorgesehen ist und die dann aufgrund dieses Signals für eine entsprechende interne Einstellung der Schaltung auf den Testbetrieb oder auf den Normalbetrieb sorgt.

So können z. B. die Testfunktionen vorgesehenen Schaltungsteile in der integrierten Schaltung aktiviert werden, indem eine in der angedeuteten Weise intern angeschlossene Signaleingangselektrode für den Testbetrieb mit einer Signalspannung beaufschlagt wird, die größer als die normale Betriebsspannung des IC-Bausteins ist. Dabei muß jedoch sichergestellt sein, daß die Testfunktion nicht bei einer für den Normalbetrieb vorgesehenen Signalspannung an dem genannten Signalanschluß auslösbar ist. Andererseits muß die Spannung für das Testsignal aus verständlichen Gründen noch unterhalb der maximal zulässigen Spannungsbeaufschlagung der integrierten Schaltung liegen. Außerdem soll ein Stromfluß über den besagten Eingang bei Beaufschlagung mit dem Testsignal möglichst vermieden werden. Ferner ist es wünschenswert, wenn dieser Testbetrieb nur dann möglich ist, wenn in dem besagten Baustein vorher für den normalen Betrieb vorgesehene Schaltungsteile durch redundante Schaltungsteile ersetzt worden sind, während in zweckmäßiger Weise vorher eine absolute Stillegung der für den Testbetrieb vorgesehenen Schaltungsteile gegeben ist. Damit hat man nämlich eine Möglichkeit, bei mit Redundanz versehenen und schaltungsmäßig miteinander übereinstimmend ausgestalteten IC's solche, bei denen redundante Teile bereits in den Normalbetrieb eingeschaltet sind, von solchen, bei denen dies nicht der Fall ist, auf einfache Weise zu unterscheiden.

Es ist nun Aufgabe der vorliegenden Erfindung, eine der eingangs gegebenen Definition entsprechende digitale MOS-Halbleiterschaltung entsprechend den angegebenen Gesichtspunkten auszugestalten.

Hierzu ist erfindungsgemäß der mit den beiden Signalarten zu beaufschlagende Signaleingang mit dem Gate eines ersten MOS-Feldeffekttransistors verbunden, dessen Drain am Versorgungspotential liegt und dessen Source über die Source-Drainstrecke eines zweiten MOS-Feldeffekttransistors einerseits mit dem Eingang eines Schmitt-Triggers und andererseits mit dem Drain eines dritten MOS-Feldeffekttransistors verbunden ist, dessen Gate am Versorgungspotential und dessen Source am Bezugspotential liegt, daß dabei der Ausgang des Schmitt-Triggers zur Steuerung des ersten Eingangs einer mit zwei Eingängen versehenen Ausgangsverstärkerschaltung dient, die ihrerseits sowohl an dem Versorgungspotential als auch an dem Bezugspotential liegt und deren zweiter Eingang mittels eines zum einen aus einer Reihenschaltung einen vierten und fünften MOS-Feldeffekttransistors einer auftrennbaren Verbindung und einem UND-Gatter mit zwei Eingängen bestehenden Schaltungsteils gesteuert ist, daß dabei in diesem Schaltungsteil der fünfte MOS-Feldeffekttransistor mit seinem Sourceanschluß am Bezugspotential und mit seinem Drainanschluß über die auftrennbar ausgestaltete Verbindung sowohl an den einen Eingang des UND-Gatters als auch an den Sourceanschluß des vierten MOS-Feldeffekttransistors gelegt ist, dessen Drainanschluß am Versorgungspotential liegt, daß ferner zur Steuerung des fünften MOS-Feldeffekttransistors ein erstes Taktsignal, zur Steuerung des vierten MOS-Feldeffekttransistors ein zweites Taktsignal und zur Steuerung des zweiten Eingangs des UND-Gatters ein drittes Taktsignal vorgesehen ist, daß außerdem der Ausgang des UND-Gatters einerseits zur Steuerung des zweiten MOS-Feldeffekttransistors als auch zur Steuerung des zweiten Eingangs des Ausgangsverstärkers dient und daß schließlich das am Ausgang des Ausgangsverstärkers anfallende Signal zur Aktivierung und/oder Steuerung weiterer Teile der MOS-Halbleiterschaltung dient.

Eine der Erfindung entsprechende Schaltung in einfacher Ausführung ist in Figur 1 dargestellt. Figur 2 zeigt das Ansprechverhalten auf die an den Signaleingang angelegten Spannungspegel. In Figur 3 ist eine zweckmäßige Weiterbildung der Erfindung gezeigt, während in Fig. 4 das Zeitverhalten der für die Beaufschlagung der erfindungsgemäßen Schaltung erforderlichen Impulse im Verein mit einem am Signaleingang anliegenden Steuersignal dargestellt ist.

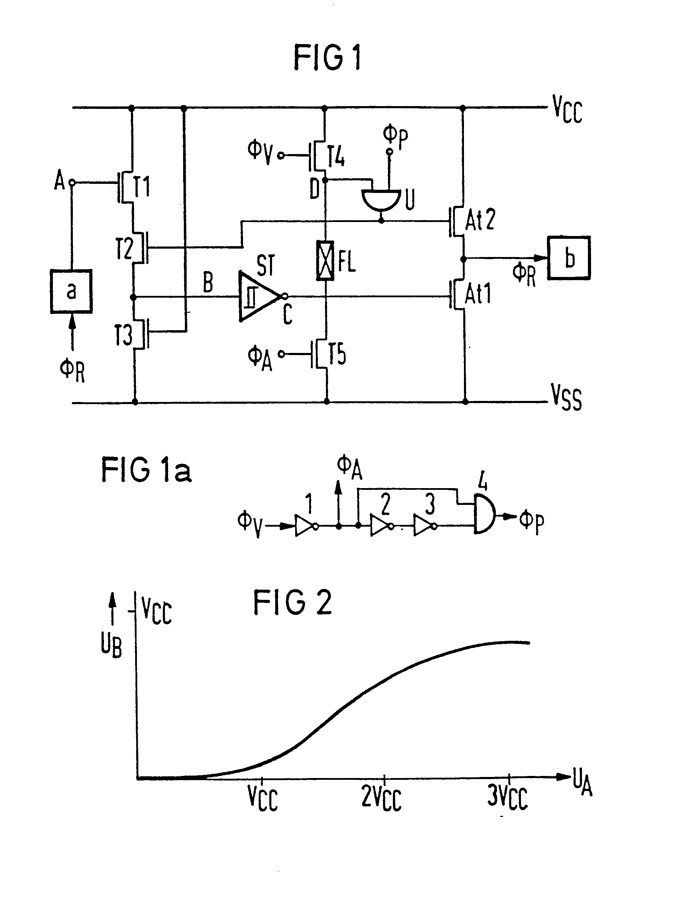

Bei dem in Fig. 1 dargestellten Schaltbild einer ersten Ausführung der erfindungsgemäßen Schaltung hat man den mit zwei Signalarten A mit unterschiedlichem Pegel zu beaufschlagenden Schaltungsteil (den Schwellwertschalter) und außerdem den für den Normalbetrieb vorgesehenen Schaltungsteil a. Es dient der Schaltungsteil a dem Normal- oder Nutzbetrieb der Schaltung und der Schaltungsteil b dem Testbetrieb. Durch die zu erzeugenden Signale $\Phi_R$ wird die Testschaltung b aktiviert. Gleichzeitig können die Signale $\Phi_R$ benutzt werden, den für den Normalbetrieb vorgesehenen Schaltungsteil a zu deaktivieren.

Nun liegt gemäß der Definition der Erfindung ein erster MOS-Feldeffekttransistor T1 mit seinem Gate an den besagten Signalanschluß A, mit seinem Drain am Versorgungspotential $V_{cc}$ und mit seinem Sourceanschluß über die Source-Drainstrecke eines zweiten MOS-Feldeffekttransistors T2 einerseits am Eingang B eines Schmitt-Triggers ST und andererseits über die Source-Drainstrecke eines dritten MOS-Feldeffekttransistors am Bezugspotential $V_{ss}$. Das Gate des dritten Transistors T3 ist unmittelbar mit dem Versorgungspotential $V_{cc}$ verbunden, während das Gate des zweiten MOS-Feldeffekttransistors T2 durch den Ausgang eines UND-Gatters U gesteuert ist.

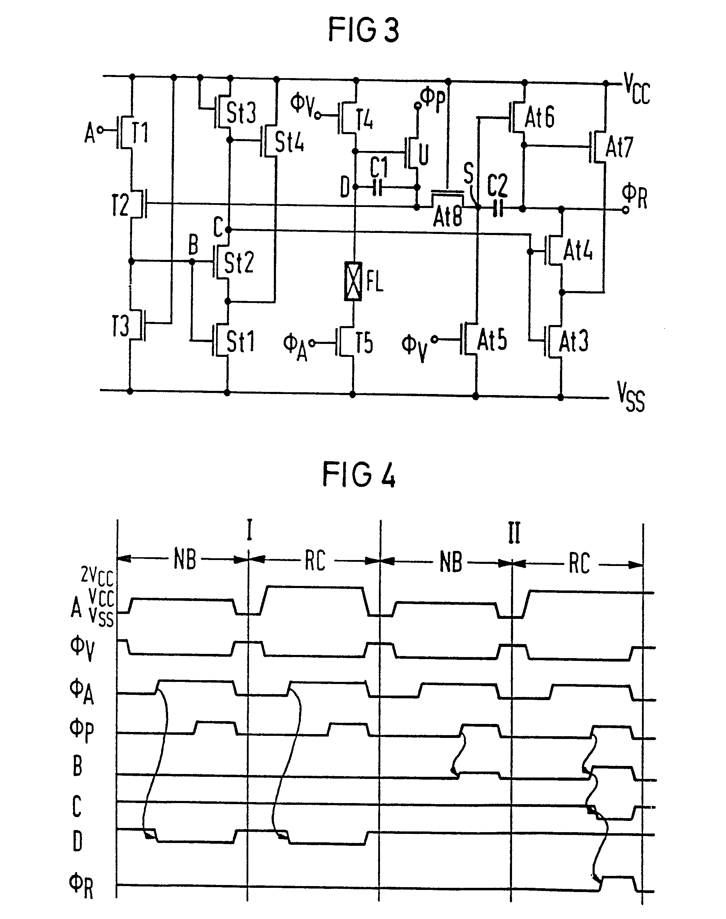

An dieser Stelle ist festzustellen, daß in den in Fig. 1 und Fig. 3 dargestellten Ausführungsbeispiel die in der Schaltung verwendeten Transistoren alle selbstsperrend und vom selben Kanalleitungstyp, insbesondere von n-Kanaltyp sind. Zu dem UND-Gatter ist noch zu bemerken, daß dieses, wie auch aus Fig. 3 ersichtlich, durch einen einzigen MOS-Feldeffekttransistor vom selbstsperrenden Typ realisiert werden kann.

Der Ausgangsverstärker ist bei der in Fig. 1 dargestellten Ausführung der Erfindung durch zwei in Serie liegende Ausgangstransistoren $At_1$ und $At_2$ gegeben, wobei der Feldeffekttransistor $At_1$ mit seinem Sourceanschluß am Bezugspotential $V_{ss}$ und der Feldeffekttransistor $At_2$ mit seinem Drainanschluß an ersorgungspotential $V_{cc}$ liegt. Der Sourceanschluß des Transistors $At_2$ sowie der Drainanschluß des Transistors $At_1$ bilden zusammen den das gewünschte Signal $\Phi_R$ liefernden Ausgang.

Zur Beaufschlagung des Gates des am Bezugspotential $V_{ss}$ liegenden Transistors $At_1$ im Ausgangsverstärker dient der Ausgang C des Schmitt-Triggers ST. Zur Steuerung des Gates des am Versorgungspotential liegenden Transistors $At_2$ ist hingegen der Ausgang des UND-Gatters U vorgesehen, welcher, wie bereits bemerkt, zur Steuerung des Gates des zweiten MOS-Feldeffekttransistors T2 dient.

Ein der Definition der Erfindung entsprechender fünfter MOS-Feldeffekttransistorder an seinem Gate durch ein erstes Taktsignal $\Phi_A$ gesteuert ist, liegt mit seinem Sourceanschluß am Bezugspotential $V_{ss}$ und mit seinem Drain unter Vermittlung einer auftrennbaren Verbindung FL sowohl an dem einen Eingang des UND-Gatters U als auch am Sourceanschluß des vierten MOS-Feldeffekttransistors T4 entsprechend der Definition der Erfindung, dessen Drainanschluß an der Versorgungsklemme für das Versorgungspotential $V_{cc}$ liegt und dessen Gate durch eine zweite Impulsfolge gesteuert ist. Zur Steuerung des zweiten Eingangs des UND-Gatters U dient eine dritte Impulsfolge $\Phi_p$.

Die beschriebene Schaltung gemäß Fig. 1 unterscheidet sich von der Schaltung gemäß Fig. 3 darin, daß in der Ausführung gemäß Figur 3 eine kompliziertere Ausgestaltung des Ausgangsverstärkers sowie eine Ausführungsform des Schmitt-Triggers ST sowie die oben erwähnte Realisierung des UND-Gatters U durch einen MOS-Feldeffekttransistor gegeben ist. Zunächst sollen noch diese Ausführungsmöglichkeiten gemäß Figur 3 beschrieben werden.

Hinsichtlich der Schaltung und Steuerung der Transistorenkette T1, T2 und T3 mit den Signaleingang A ist Übereinstimmung mit der Ausgestaltung gemäß Figur 1 gegeben.

Bei der in Figur 3 verwendeten Ausgestaltung des SchmittTriggers ST sind vier MOS-Feldeffekttransistoren $St_1$ bis $St_4$ vorgesehen, wobei das Gate des ersten dieser Transistoren, nämlich des Transistors $St_1$, sowie das Gate des zweiten Transistors $St_2$ den Signaleingang B des Schmitt-Triggers darstellen. Der erste dieser Transistoren

St$_1$ liegt mit seinem Sourceanschluß am Bezugspotentail V$_{ss}$ uns mit seinem Drain einerseits am Sourceanschluß des zweiten der zuletzt genannten Transistoren, nämlich des Transistors St$_2$ als andererseits über die Source-Drainstrecke des vierten Transistors St$_4$ am Versorgungspotential V$_{cc}$. Der dritte Transistor St$_3$ liegt mit seiner Source sowohl am Signalausgang C des Schmitt-Triggers als auch am Gate des vierten Transistors St$_4$ und ist mit seinem Gate und seinem Drain an das Versorgungspotential V$_{cc}$ gelegt.

Hinsichtlich der Schaltung des durch das erste Taktsignal $\Phi_A$ und des durch das zweite Taktsignal $\Phi_V$ zu steuernden fünften Transistors T5 bzw. vierten Transistors T4 gemäß der Definition der Erfindung und der Verwendung der auftrennbaren Verbindung EL ist Übereinstimmung bei beiden Figuren 1 und 3 gegeben. Zur Realisierung des UND-Gatters U ist ein MOS-Feldeffekttransistor gegeben, dessen Drainanschluß durch die dritte Impulsfolge $\Phi_P$ beaufschlagt ist und dessen den Ausgang des UND-Gatters bildender Sourceanschluß einerseits unmittelbar an das Gate des zweiten Transistors T2 der Definition der Erfindung gelegt und anderseits über einen Kondensator C1 mit dem Sourceanschluß des Transistors T4 und damit mit dem eigenen Gate verbunden ist. Schließlich liegt der Ausgang des UND-Gatters U am Eingang der Verstärkerschaltung am Ausgang der Gesamtschaltung, der beispielsweise auch in der aus Figur 1 ersichtlichen Weise (At$_1$, At$_2$) ausgestaltet sein könnte.

Bei der in Figur 3 dargestellten Ausführung der Erfindung ist jedoch der Ausgangsverstärker ebenfalls als eine Schmitt-Triggerschaltung ausgestaltet, die in diesem Fall mit einer Bootstrapschaltung kombiniert ist. Zu ihrer Realisierung sind sechs MOS-Feldeffekttransistoren At$_3$ - At$_8$ und ein Kondensator C2 vorgesehen, die in folgender Weise geschaltet sind.

Der durch den Ausgang des UND-Gatters U beaufschlagte eine Eingang des Ausgangsverstärkers ist durch den einen stromführenden Anschluß des Transistors At$_8$ gegeben, dessen Gate am Versorgungspotential V$_{cc}$ und dessen anderer stromführende Anschluß an einem Schaltungsknoten S liegt. Dieser Schaltungsknoten S führt über die Source-Drainstrecke des an seinem Gate durch den (zugleich zur Steuerung von T4 eingesetzten) zweiten Taktimpuls $\Phi_V$ gesteuerten MOS-Feldeffekttransistor At$_5$ zum Bezugspotential V$_{ss}$. Er führt außerdem über den Kondensator C2 zu dem die gewünschten Impulse $\Phi_R$ liefernden Signalausgang des Ausgangsverstärkers. Schließlich ist dieser Knoten 5 auch mit dem Gate des Transistors At$_6$ verbunden, dessen Sourceanschluß am Signalausgang und dessen Drain am Versorgungspotential V$_{cc}$ liegt. Zu bemerken ist noch, daß der Ausgang des UND-Gatters U und damit der Eingang At$_8$ über einen Bootstrap-Kondensator C1 am Knoten D liegt.

Der Ausgang C des Schmitt-Triggers St liegt in diesem Fall am Gate des unmittelbar mit dem Bezugspotential V$_{ss}$ verbundenen MOS-Feldeffekttransistors At$_3$ und am Gate des mit dem Transistor At$_3$ in Reihe liegenden und mit seinem Drainanschluß am Signalausgang liegenden MOS-Feldeffekttransistors At$_4$. Ein Schaltungspunkt zwischen den beiden zuletzt genannten Transistoren At$_3$ und At$_4$ liegt über die Source-Drainstrecke des MOS-Feldeffekttransistors At$_7$ am Versorgungspotential V$_{cc}$ während das Gate des zuletzt genannten Transistors At$_7$ unmittelbar mit dem Ausgang des Ausgangsverstärkers verbunden ist.

Fig. 4 zeigt eine Möglichkeit für die Beaufschlagung des Signaleingangs A sowie den Zeitverlauf der Impulse $\Phi_V$ (= 2. Taktimpuls), $\Phi_A$ ( = 1. Taktimpuls), $\Phi_P$ (= 3. Taktimpuls) und der Zustände am Eingang B, am Ausgang C des Schmitt-Triggers St, sowie am Sourceanschluß des mit dem UND-Gatters U verbundenen vierten Transistors T4 gemäß der Definition der Erfindung (D) und schließlich am Ausgang$_1$ das heißt also den Zeitverlauf der zu erzeugenden Impulse $\Phi_R$. Vor den Eingehen auf diesbezügliche Einzelheiten soll jedoch zunächst auf das erhalten der Schaltung gemäß Fig. 1 bzw. 3 näher eingegangen werden.

Das der Steuerung des vierten Transistors T4 dienende Taktsignal $\Phi_V$ (also das zweite Taktsignal gemäß der Definition der Erfindung) dient der Aufladung des durch diesen Transistor gesteuerten Eingangs des UND-Gatters U auf den Spannungswert(V$_{cc}$ - U$_T$) (U$_T$= Einsatzspannung von T4). Das zur Steuerung- des fünften Transistors dienende erste Taktsignal $\Phi_A$ geht von Wert des Bezugspotentials V$_{ss}$ auf den Wert des Versorgungspotentials V$_{cc}$ nachdem das Taktsignal $\Phi_V$ auf den Wert V$_{ss}$ geschaltet wurde. Damit wird der durch T4 gesteuerte Eingang des UND-Gatters U wieder entladen, sofern die Verbindung zwischen T5 und T4 (FL) intakt ist.

Falls hingegen die Verbindung aufgetrennt ist, entfällt die Wirkung des Taktsignals $\Phi_A$ auf das UND-Gatter U.

Bei dem zur Beaufschlagung des UND-Gatters U dienenden dritten Taktsignal $\Phi_P$ ist festzustellen, daß seine ansteigende Flanke die ansteigende Flanke des Ausgangssignals $\Phi_R$ bestimmt, sobald am Signaleingang A der Schaltung das Signal mit dem überhöhten (d.h. oberhalb von V$_{cc}$ liegenden) Pegel anhängig ist. Die Taktsignale $\Phi_A$ und $\Phi_P$ können beide zweckmäßigerweise mit der ansteigenden Flanke des Signals $\Phi_V$ auf das Bezugspotential V$_{ss}$ zurückgesetzt werden.

Die durch den Signaleingang gesteuerte Reihenschaltung der Transistoren T1, T2 und T3 führt zwischen dem zweiten Transistor T2 und dem dritten Transistor T3 und damit am Eingang B des Schmitt-Triggers St zu den aus Figur 2 ersichtlichen Verhalten der Spannung U$_B$ zwischen dem Punkt B und dem Bezugspotential V$_{ss}$ in Abhängigkeit vom Wert der am Signaleingang A liegenden und auf das Bezugspotential V$_{ss}$ referierten Spannung U$_A$. Dabei ist die Steilheit der Kurve durch die Dimensionierung der Transtoren T1 - T3 einstellbar. Das in Fig. 2 ersichtliche Verhalten entspricht einer optimalen Dimensionierung. Mit diesem ist angestrebt, daß die Schaltschwelle des Schmitt-Triggers ST dann erreicht wird, wenn die Spannung $U_A$ am Signaleingang A zwischen dem einfachen und dem doppelten Wert der Versorgungsspannung $V_{cc}$ liegt.

Über den zweiten Transitor T2 kann unter Vermittlung des UND-Gatters U das dritte Taktsignal $\Phi_p$ Einfluß auf die Kombination der Transistoren T1 bis T3 nehmen, wodurch der Leistungsverbrauch in der in Fig. 1 und 3 dargestellten Schaltung auf die aktiven Zeitbereiche des Arbeitszyklus der Schaltung beschränkt wird. Der Takt $\Phi_p$ kann ersichtlich das UND-Gatter U solange nicht passieren, solange die auftrennbare Verbindung FL noch intakt ist. In diesem Falle wird dann die zwischen T4 und dem UND-Gatter U bestehende Verbindung, also der Knoten D, über den fünften Transistor T5 und die auftrennbare Verbindung FL mit dem Beginn eines aktiven Zyklus auf den Potentialwert $V_{ss}$ geklemmt. Der zweite Takt und der von ihm gesteuerte vierte Transistor T4 sorgen dann dafür, daß eine Vorladung des Knotens D stattfindet. In diesem Betriebszustand können dann auch keine Querströme existieren, so daß der Stromverbrauch der in Fig. 1 und 3 dargestellten und zur Erzeugung der Signale $\Phi_R$ dienenden Schaltung vernachlässigbar klein wird. Die Entstehung eines Ausgangssignals $\Phi_R$ ist dann ausgeschlossen. Wird nun die auftrennbare Verbindung FL unterbrochen, so entsteht beim Anlegen einer entsprechend hoch bemessenen Signalspannung $U_A$ an Signaleingang A, z. B. einer Spannung $U_A = 2V_{cc}$, das Ausgangssignal, das zur Aktivierung eines bisher inaktiven Schaltungsteils b, z. B. einer Testschaltung, z. B. in der aus Fig. 1 ersichtlichen Weise, herangezogen werden kann, indem durch die Signale $\Phi_R$ z. B. der dem Testbetrieb dienende Schaltungsteil b auf den aktiven Zustand geschaltet wird. Falls dies erwünscht ist, kann man dann ohne Schwierigkeiten schaltungsmäßig mittels des Taktes $\Phi_R$ die Beaufschlagung des für den Normalbetrieb vorgesehenen Schaltungsteils a durch den Signaleingang A verhindern.

Aus der in Fig. 4 gezeigten Beaufschlagung einer Schaltung gemäß Fig. 1 und Fig. 3 ersieht man, daß der am Signaleingang A anstehende Pegel Werte zwischen $V_{ss}$ und $V_{cc}$ und im Testbetrieb Werte zwischen $V_{cc}$ und $2V_{cc}$ annehmen kann. Da bei digitalen integrierten n-Kanal-MOS-Schaltungen die zulässige Gatespannung der Transistoren üblicherweise mindestens das doppelte der maximalen Betriebsspannung beträgt, so ist bei einer solchen Beaufschlagung des Signaleingangs eine Gefährdung der Schaltung nicht gegeben.

Das Zeitverhalten für den Normalbetrieb ist in den mit NB bezeichneten Spalten und das Zeitverhalten für den Testbetrieb in den mit RC bezeichneten Spalten im Diagramm gemäß Figur 4 dargestellt.

Um die das gewünschte Zeitverhalten zeigenden Taktfolgen $\Phi_V$, $\Phi_A$ und $\Phi_p$ zu erhalten, geht man am einfachsten von der zweiten Impulsfolge $\Phi_V$ aus, und beaufschlagt mit dieser die aus Figur 1a ersichtliche Schaltung. Diese besteht aus einem ersten Inverter 1, dessen Eingang mit den Impulsen beaufschlagt ist und dessen Ausgang die Impulse $\Phi_A$ liefert. Außerdem steuert der Ausgang des ersten Inverters 1 den Eingang eines zweiten Inverters 2 sowie den einen Eingang eines UND-Gatters 4. Der zweite Eingang dieses UNDGatters 4 wird durch den Ausgang eines dritten Inverters 3 gesteuert, der seinerseits am Ausgang des zweiten Inverters 2 liegt. Der Ausgang des UND-Gatters 4 liefert $\Phi_p$.

**Patentansprüche**

1. Integrierte digitale MOS-Halbleiterschaltung mit einem durch zwei Signale mit unterschiedlichem Pegel zu beaufschlagenden Signaleingang, bei der aufgrund der Signale mit dem einen Pegel eine erste Betriebsart und aufgrund der Signale mit dem zweiten Pegel eine zweite Betriebsart auslösbar ist, *dadurch gekennzeichnet,* daß der mit den beiden Signalarten zu beaufschlagende Signaleingang (A) mit dem Gate eines ersten MOS-Feldeffekttransistors (T1) verbunden ist, dessen Drain am Versorgungspotential ($V_{cc}$) liegt und dessen Source über die Source-Drainstrecke eines zweiten MOS-Feldeffekttransistors (T2) einerseits mit dem Eingang (B) eines Schmitt-Triggers (ST) und andererseits mit dem Drain eines dritten MOS-Feldeffektransistors (T3) verbunden ist, dessen Gate am Versorgungspotential ($V_{cc}$) und dessen Source am Bezugspotential ($V_{ss}$) liegt, daß dabei der Ausgang (C) des Schmitt-Triggers (ST) zur Steuerung des ersten Eingangs eines mit zwei Eingängen versehene Ausgangsverstärkers dient, der seinerseits sowohl an dem Versorgungspotential als auch an dem Bezugspotential liegt und dessen zweiter Eingang mittels eines zum einen aus einer Reihenschaltung einer vierten und fünften MOS-Feldeffekttransisistors (T4 u. T5) und zum andern aus einem UND-Gatter (U) mit zwei Eingängen bestehenden und gleichzeitig zur Steuerung des zweiten MOS-Feldeffekttransistors (T2) dienenden Schaltungsteils gesteuert ist, daß dabei in diesem Schaltungsteil der fünfte MOS-Feldeffekttransistor (T5) mit seinem Sourceanschluß am Bezugspotential ($V_{ss}$) und mit seinem Drainanschluß über eine auftrennbare Verbindung (FL) sowohl an den einen Eingang des UND-Gatters als auch an den Sourceanschluß des vierten MOS-Feldeffektransistors (T4) gelegt ist, dessen Drainanschluß am Versorgungspotential ($V_{cc}$) liegt, daß ferner zum Steuerung des fünften MOS-Feldeffekttransistors (T5) ein erstes Taktsignal $\Phi_A$, zur Steuerung des vierten MOS-Feldeffekttransistors (T4) an zweites Taktsignal $\Phi_V$ und zur Steuerung des zweiten Eingangs des UND-Gatters (U) ein drittes Taktsignal ($\Phi_p$) vorgesehen ist, daß außerdem der Ausgang des UND-Gatters (U) einerseits zur Steuerung des zweiten MOS-Feldeffekttransistors (T2) als auch zur Steuerung des zweiten Eingangs des Ausgangsverstärkers dient und daß schließlich das am Ausgang des

Ausgangsverstärkers anfallende Signal (Φr) zur Aktivierung und/oder Steuerung weiterer Teile (b) der MOS-Halbleiterschaltung dient.

2. Halbleiterschaltung nach Anspruch 1, *dadurch gekennzeichnet,* daß der zweite Transistor (T2) unmittelbar mit seinem Gate am Ausgang des UND-Gatters (U) liegt.

3. Halbleiterschaltung nach, Anspruch 1 oder 2, *dadurch gekennzeichnet,* daß der Ausgangsverstärker aus der Reihenschaltung zweier MOS-Feldeffekttransistoren (At1, At2) besteht, wobei der Sourceanschluß des einen Transistors (At1) am Bezugspotential (Vss) und sein Gate am Ausgang (C) des Schmitt-Triggers (ST) liegt, während der Drainanschluß des anderen Transistors (At2) am Versorgungspotential (Vcc) und sein Gate mit dem Ausgang des UND-Gatters, z. B. unmittelbar, verbunden ist, während der Signalausgang (ΦR) durch einen Schaltungspunkt zwischen den beiden Transistoren (At1, At2) gegeben ist.

4. Halbleiterschaltung nach Anspruch 1 oder 2, *dadurch gekennzeichnet* daß der Ausgangsverstärker durch die Kombination von fünf MOS-Feldeffekttransistoren (At3 - At8) und eines Kondensatoren (C2) gegeben ist, in der der durch das UND-Gatter (U) zu beaufschlagende Eingang durch den einen stromführenden Eingang eines - mit seinem Gate am Versorgungspotential (Vcc) liegenden - ersten Transistors (At8) gegeben ist, dessen zweiter stromführender Anschluß einerseits über die Source-Drainstrecke eines vom zweiten Taktsignal (Φv) gesteuerten zweiten Transistors (At5) am Bezugspotential (Vss) und andererseits am Gate eines - zwischen dem Versorgungspotential (Vcc) und dem Signalausgang des Verstärkers liegenden - dritten Transistors (At6) als auch über einen Kondensator am Signalausgang (ΦR) des Ausgangsverstärkers liegt, daß außerdem der Signalausgang ΦR über die Reihenschaltung eines vierten und eines fünften Transistors (At3, At4) mit dem Bezugspotential (Vss) verbunden und das Gate des vierten und des fünften Transistors (At3, At4) durch den Ausgang (C) des Schmitt-Triggers (ST) beaufschlagt ist, und daß schließlich ein Schaltungspunkt zwischen dem vierten und fünften Transistor (At3, At4) über die Source-Drainstrecke eines sechsten Transistors (At7) mit den Versorgungspotential (Vcc) verbunden und das Gate des sechsten Transistors (At7) an den Ausgang (ΦR) des Verstärkers gelegt ist.

5. Halbleiterschaltung nach einem der Ansprüche 1 bis 4, *dadurch gekennzeichnet,* daß das UND-Gatter (U) durch einen mit seinem Gate mit dem Sourceanschluß des vierten Transistors (T4) verbundenen und an seinem Drain durch die Impulse der dritten Taktfolge (Φp) beaufschlagten MOS-Feldeffekttransistoren (U) gegeben ist, dessen Sourceanschluß einerseits an das Gate des zweiten MOS-Feldeffekttransistors (T2) und andererseits an den zweiten Eingang (At2; At8) des Ausgangsverstärkers angeschalte ist.

6. Halbleiterschaltung nach einem der Ansprüch 1 bis 5, *dadurch gekennzeichnet,* daß der von vier MOS-Feldeffekttransistoren (St1 - St4) gebildete Schmitt-Trigger (ST) derart aufgebaut ist, daß sein Eingang (B) durch das Gate von zwei dieser Transistoren (St1, St2) gegeben ist, die zueinander in Reihe geschaltet sind, wobei der eine Transistor (St1) am Bezugspotential (Vss) und der andere am Ausgang (C) des Schmitt-Triggers (ST) liegt, daß außerdem der Ausgang (C) des Schmitt-Triggers (ST) über einen als Widerstand geschalteten weiteren Transistor (St3) am Versorgungspotential (Vcc) und außerdem ein Schaltungspunkt zwischen den beiden am Eingang (B) liegenden Transistoren (St1, St2) des Schmitt-Triggers über einen weiteren Transistor (St4) mit dem Versorgungspotential verbunden ist, wobei das Gate dieses weiteren Transistors (St4) am Ausgang (C) des Schmitt-Triggers (ST) liegt.

## Claims

1. Integrated digital MOS semiconductor circuit with a signal input to be fed with two signals of different levels, in which a first operating mode can be initiated on the basis of the signals with the one level and a second operating mode can be initiated on the basis of the signals with the second level, characterized in that the signal input (A) to be fed with the two types of signal is connected to the gate of a first MOS field-effect transistor (T1), the drain of which is at the supply potential (Vcc) and the source of which is connected via the source-drain link of a second MOS fieldeffect transistor (T2) on the one hand to the input (B) of a Schmitt trigger (ST) and on the other hand to the drain of a third MOS field-effect transistor (T3), the gate of which is at the supply potential (Vcc) and the source of which is at the reference potential (Vss), in that the output (C) of the Schmitt trigger (ST) here has the purpose of controlling the first input of an output amplifier provided with two inputs, which amplifier, for its part, is both at the supply potential and at the reference potential, and the second input of which is controlled by means of a circuit component consisting, on the one hand, of a series connection of a fourth and fifth MOS field-effect transistor (T4 and T5) and, on the other hand, of an AND gate (U) with two inputs, and at the same time having the purpose of controlling the second MOS field-effect transistor (T2), in that in this circuit component the fifth MOS field-effect transistor connection (FL) both to the one input of the AND gate and to the source terminal of the fourth MOS field-effect transistor (T4), the drain terminal of which is at the supply potential (Vcc), in that also to control the fifth MOS field-effect transistor (T5) a first clock signal ΦA is provided, to control the fourth MOS field-effect transistor (T4) a se-

cond clock signal (Φ$_V$) is provided and to control the second input of the AND gate (U) a third clock signal (Φ$_P$) is provided, in that, in addition, the output of the AND gate (U) has, on the one hand, the purpose of controlling the second MOS field-effect transistor (T2) and also of controlling the second input of the output amplifier and in that, finally, the signal (Φ$_T$) occurring at the output of the output amplifier has the purpose of activating and/or controlling further components (b) of the MOS semiconductor circuit.

2. Semiconductor circuit according to Claim 1, characterized in that the second transistor (T2) is positioned directly with its gate at the output of the AND gate (U).

3. Semiconductor circuit according to Claim 1 or 2, characterized in that the output amplifier consists of the series connection of two MOS field-effect transistors (At$_1$, At$_2$), the source terminal of the one transistor (At1) being at the reference potential (V$_{ss}$) and its gate being connected to the output (C) of the Schmitt trigger (ST), while the drain terminal of the other transistor (At2) is at the supply potential (V$_{cc}$) and its gate is, for example directly, connected to the output of the AND gate, while the signal output (Φ$_R$) is given by a switching point between the two transistors (At$_1$, At$_2$).

4. Semiconductor circuit according to Claim 1 or 2, characterized in that the output amplifier is given by the combination of five MOS field-effect transistors (At$_3$ - At$_8$) and a capacitor (C2), in which combination the input to be by the AND gate (U) is given by the one current-carrying input of a first transistor (At$_8$) - with its gate at the supply potential (V$_{cc}$) - of which transistor the second current-carrying terminal is, on the one hand, at the reference potential (V$_{ss}$) via the source-drain link of a second transistor (At$_5$) controlled by the second clock signal (Φ$_V$) and, on the other hand, is connected to the gate of a third transistor (At$_6$) - situated between the supply potential (V$_{cc}$) and the signal output of the amplifier - as well as to the signal output (Φ$_R$) of the output amplifier via a capacitor (C2), in that, in addition, the signal output (Φ$_R$) is connected to the reference potential (V$_{ss}$) via the series connection of a fourth and a fifth transistor (At$_3$, At$_4$) and the gate of the fourth and the fifth transistor (At$_3$, At$_4$) is triggered by the output (C) of the Schmitt trigger (ST), and in that, finally, a switching point between the fourth and fifth transistor (At$_3$, At$_4$) is connected via the sourcedrain link of a sixth transistor (At$_7$) to the supply potential (V$_{cc}$) and the gate of the sixth transistor (At$_7$) is connected to the output (Φ$_R$) of the amplifier.

5. Semiconductor circuit according to one of Claims 1 to 4, characterized in that the AND gate (U) is given by a MOS field-effect transistor (U), which is connected by its gate to the source terminal of the fourth transistor (T4) and receives the pulses of the third clock sequence (Φ$_p$) at its drain, of which transistor the source terminal is connected, on the one hand, to the gate of the second MOS field-effect transistor (T2) and, on the other hand, to the second input (At$_2$; At$_8$) of the output amplifier.

6. Semiconductor circuit according to one of Claims 1 to 5, characterized in that the Schmitt trigger (ST) formed by four MOS field-effect transistors (St$_1$ - St$_4$) is designed in such a way that its input (B) is given by the gate of two of these transistors (St$_1$, St$_2$), which are connected in series with each other, the one transistor (St$_1$) being at the reference potential (V$_{ss}$) and the other being trigger (ST) is connected to the supply potential (V$_{cc}$) via a further transistor (St$_3$) connected as a resistor and, in addition, a switching point between the two transistors (St$_1$, St$_2$) of the Schmitt trigger, which are situated at the input (B), is connected to the supply potential via a further transistor (St$_4$), the gate of this further transistor (St$_4$) being connected to the output (C) of the Schmitt trigger (ST).

## Revendications

1. Circuit intégré numérique à semi-conducteurs MOS, possédant une entrée des signaux à attaquer par deux signaux de niveaux différents, dans lequel les signaux d'un premier niveau déclenchent un premier mode de fonctionnement et dans lequel des signaux d'un deuxième niveau déclenchent un deuxième mode de fonctionnement, *caractérisé en ce* que l'entrée des signaux (A) à attaquer par les deux types de signaux est reliée à la grille d'un premier transistor à effet de champ MOS (T1) dont le drain est relié au potentiel d'alimentation (V$_{cc}$) et dont la source est reliée à travers le parcours source-drain d'un deuxième transistor à effet de champ MOS (T2) d'une part à l'entrée (B) d'une bascule de Schmitt (ST) et d'autre part au drain d'un troisième transistor à effet de champ MOS (T3) dont la grille est reliée au potentiel d'alimentation (V$_{cc}$) et la source au potentiel de référence (V$_{ss}$), que la sortie (C) de la bascule de Schmitt (ST) sert à commander la première entrée d'un amplificateur de sortie muni de deux entrées et qui est lui-même connecté à la fois au potentiel d'alimentation et au potentiel de référence et dont la seconde entrée est commandée au moyen d'une partie de circuit constituée d'une part du montage en série d'un quatrième et d'un cinquième transistor à effet de champ MOS (T4 et T5) et, d'autre part, d'une porte ET (U) ayant deux entrées, et servant en même temps à la commande du deuxième transistor à effet de champ MOS (T2), que le cin- de référence (V$_{ss}$) et par sa connexion de drain, à travers une liaison sectionnable (FL), la fois à une entrée de la porte ET et à la connexion de source du quatrième transistor à effet de champ MOS (T4) dont la connexion de drain est reliée au potentiel d'alimentation (V$_{cc}$), que, en plus, on a prévu un premier signal d'horloge Φ$_A$ pour la commande du cinquième transistor à effet de champ MOS (T5), un deuxième signal d'horloge ($\Phi_v$) pour la commande du quatrième transistor à effet de champ MOS (T4) et un troisième signal d'horloge ($\Phi_p$) pour la commande de la seconde entrée de la porte ET (U), que, en outre, la sortie de la porte ET (U) sert à commander d'une part le deuxième transistor à effet de champ MOS (T2) et d'autre part la seconde entrée de l'amplificateur de sortie et que, enfin, le signal ($\Phi_R$) produit sur la sortie de l'amplificateur de sortie sert à activer et/ou commander d'autres parties (b) du circuit à semi-conducteur MOS.

2. Circuit selon la revendication 1, caractérisé en ce que le deuxième transistor (T2) est relié directement par sa grille à la sortie de la porte ET (U).

3. Circuit selon la revendication 1 ou 2, caractérisé en ce que l'amplificateur de sortie est formé par le montage en série de deux transistors à effet de champ MOS (At$_1$, At$_2$), montage dans lequel la connexion de source d'un transistor (At$_1$) est reliée au potentiel de référence (V$_{ss}$) et sa grille est reliée à la sortie (C) de la bascule de Schmitt (ST), tandis que la connexion de drain de l'autre transistor (At$_2$) est reliée au potentiel d'alimentation (V$_{cc}$) et sa grille est reliée à la sortie de la porte ET, directement par exemple, tandis que la sortie des signaux ($\Phi_R$) est constituée par un point de circuit situé entre les deux transistors (At$_1$, At$_2$).

4. Circuit selon la revendication 1 ou 2, caractérisé en ce que l'amplificateur de sortie est formé par la combinaison de cinq transistors à effet de champ MOS (At$_3$ - At$_8$) et d'un condensateur (C2), combinaison dans laquelle l'entre à attaquer par la porte ET (U) est formée par une entrée, parcourue par le courant, d'un premier transistor (At$_8$) - qui est relié par sa grille au potentiel d'alimentation V$_{cc}$ - dont la seconde connexion, parcourue par le courant, est reliée d'une part au potentiel de référence (V$_{ss}$) à travers le parcours source-drain d'un deuxième transistor (At$_5$) commandé par le deuxième signal d'horloge ($\Phi_v$) et, d'autre part, à la grille d'un troisième transistor (At$_6$) connecté entre le potentiel d'alimentation (V$_{cc}$) et la sortie des signaux de l'amplificateur - ainsi que, à travers un condensateur (C2), à la sortie des signaux ($\Phi_R$) de l'amplificateur de sortie, que la sortie des signaux ($\Phi_R$) est reliée, en outre, au potentiel de référence (V$_{ss}$) à travers le montage en série d'un quatrième et d'un cinquième transistor (At$_3$, At$_4$) dont les grilles sont attaquées par la sortie (C) de la bascule de Schmitt (ST) et que, enfin, un point du circuit situé entre les quatrième et cinquième transistors (At$_3$, At$_4$) est relié au potentiel d'alimentation (V$_{cc}$) à travers le parcours source-drain d'un sixième transistor (At$_7$) dont la grille est reliée à la sortie ($\Phi_R$) de l'amplificateur.

5. Circuit selon une des revendications 1 à 4, caractérisé en ce que la porte ET (U) est formée par un transistor à effet de champ MOS (U) dont la grille est reliée à la connexion de source du quatrième transistor (T4), dont le drain est attaqué par les impulsions de la troisième suite d'impulsions d'horloge ($\Phi_p$) et dont la connexion de source est raccordée d'une part à la grille du deuxième transistor à effet de champ MOS (T2) et d'autre part à la seconde entrée (At$_2$; At$_8$) de l'amplificateur de sortie.

6. Circuit selon une des revendications 1 à 5, caractérisé en ce que la bascule de Schmitt (ST), formée de quatre transistors à effet de champ MOS (St$_1$ - St$_4$), est réalisée de manière que son entrée (B) soit constituée par les grilles de deux de ces transistors (St$_1$, St$_2$) qui sont montés en série et dont l'un (ST1) est relié potentiel de référence (V$_{ss}$) et l'autre à la sortie (C) de la bascule de Schmitt (ST) et que, en outre, la sortie (C) de la bascule de Schmitt (ST) est reliée au potentiel d'alimentation (V$_{cc}$) à travers un transistor supplémentaire (St$_3$) monté en résistance et un point du circuit, situé entre les deux transistors (St$_1$, St$_2$) se trouvant à l'entrée (B) de la bascule de Schmitt, est relié, en plus, au potentiel d'alimentation à travers un transistor supplémentaire (St$_4$) dont la grille est reliée à la sortie (C) de la bascule de Schmitt (ST).

FIG 1

FIG 1a

FIG 2

# FIG 3

# FIG 4